# FASCICULE DE BREVET EUROPEEN

(11) **EP 1 692 723 B1**
(45) Date de publication et mention de la délivrance du brevet: **30.06.2010**
(21) Numéro de dépôt: 04805611.3
(22) Date de dépôt: 02.12.2004
(51) Int. Cl.: H01L 27/10, H01L 23/525

(54) **Procédé de réalisation d'un support mémoire irréversible utilisant une déformation plastique**
Herstellungsverfahren für einen irreversiblen Speicher mittels einer plastischen Verformung
Method of manufacturing an irreversible memory using a plastic deformation

(30) Priorité: 12.12.2003 FR 0314625
(43) Date de publication de la demande: 23.08.2006
(73) Titulaire: Commissariat à l'Énergie Atomique et aux Énergies Alternatives, 75015 Paris (FR)
(72) Inventeur: BECHEVET, Bernard, F-38640 Claix (FR); GAUD, Pierre, F-38500 Coublevie (FR); SOUSA, Véronique, F-38000 Grenoble (FR)
(74) Mandataire: Hecké, Gérard
(86) Numéro de dépôt international: PCT/FR2004/003091
(87) Numéro de publication internationale: WO 2005/067050

(56) Documents cités:
- EP-A- 0 734 065
- EP-A- 0 786 808
- US-A- 4 396 998
- US-A- 5 464 989
- US-A- 5 580 809
- US-A- 6 055 180
- US-A- 6 121 688

## Description

### Domaine technique de l'invention

L'invention concerne un procédé de réalisation d'un support mémoire irréversible comportant un réseau de cellules mémoire, chaque cellule mémoire comportant une zone d'une couche active disposée entre des premier et deuxième conducteurs, une information binaire stockée dans la cellule mémoire étant déterminée par l'état de conduction électrique de la zone correspondante.

### État de la technique

Les mémoires solides à base de silicium, par exemple les mémoires de type flash, sont bien connues et très utilisées actuellement.

Classiquement, une mémoire solide comporte un réseau matriciel de conducteurs perpendiculaires superposés et isolés les uns des autres, qui sont adressés successivement par multiplexage. Aux intersections des conducteurs sont disposées des cellules mémoire. Pour réaliser une mémoire morte (ROM), les informations d'un fichier à stocker sont, par exemple, inscrites dans le matériau constituant les cellules mémoire par l'intermédiaire d'un masque de lithographie spécifique. Les étapes de masquage et de lithographie correspondantes représentent une partie considérable des coûts d'une telle mémoire.

Le brevet US6351406 décrit un support mémoire irréversible programmable comportant un réseau de cellules mémoire. Chaque cellule mémoire est adressable par un premier et un deuxième conducteur et comporte un élément de changement d'état connecté entre les premier et deuxième conducteurs. Par l'intermédiaire d'un courant fort, par exemple, on peut provoquer la fusion d'une couche fine isolante disposée entre deux électrodes et la formation d'une liaison permanente conductrice entre les deux électrodes. Ainsi, toutes les cellules mémoire du support mémoire peuvent être programmées. Cependant, les techniques de fabrication de masse de ces supports mémoire irréversibles ne sont pas fiables et présentent des coûts élevés.

D'autres types de supports mémoire irréversible, par exemple les mémoires mortes pré-enregistrées, nécessitent des étapes de masquage supplémentaires lors de la fabrication, ce qui rend leur fabrication coûteuse.

Le document US6055180 décrit un support mémoire comportant un réseau de cellules mémoire, adressables par des premiers et deuxièmes conducteurs, disposés respectivement de part et d'autre d'un média actif. Le média actif comporte au moins un matériau organique et présente des états chimiques ou physiques différents correspondant à des valeurs logiques qui peuvent être détectées par voie électrique. Chaque cellule mémoire comporte une zone du média actif constituant une connexion électrique entre les premier et deuxième conducteurs correspondant. L'écriture d'informations sur une cellule mémoire peut être effectuée par effet Joule en applicant un courant fort parcourant la zone du média correspondante. Le choix judicieux du matériau du média actif permet de changer l'impédance de la cellule de manière réversible ou irréversible.

Les documents US 5464989 et US 5580809 montrent des dispositifs de mémoire appartenant à l'art antérieur.

Le document US6121688 décrit une feuille conductrice anisotrope destinée à être intégrée dans un circuit imprimé. La feuille conductrice comporte une résine et des particules conductrices, par exemple métalliques, insérées dans la résine. La feuille est disposée entre un conducteur en aluminium et une piste conductrice d'un circuit imprimé. La piste conductrice est déformée de manière à comprimer la feuille conductrice entre la piste conductrice et le conducteur. La zone comprimée de la feuille conductrice constitue une connexion électrique entre la piste conductrice et le conducteur conductrice.

### Objet de l'invention

L'invention est définie par le procédé suivant la revendication 1.

L'invention a pour but de remédier à ces inconvénients et, en particulier, de proposer la réalisation d'un support mémoire irréversible à faible coût tout en utilisant des techniques de fabrication fiables.

Selon l'invention, ce but est atteint par les revendications annexées et, en particulier, par le fait que le procédé de réalisation du support mémoire comporte l'assemblage d'un support mémoire vierge dont la couche active est dans un état initial isolant, la fabrication d'une matrice d'estampage ayant un motif d'estampage correspondant à l'information à stocker et l'estampage du support mémoire par l'intermédiaire de la matrice d'estampage, de manière à rendre des zones prédéterminées de la couche active électriquement conductrices par déformation plastique localisée.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 et 2 illustrent un mode de réalisation particulier d'un support mémoire selon l'invention, respectivement en vue de dessus et en coupe selon l'axe A-A.
Les figures 3 à 5, d'une part, et la figure 6, d'autre part, représentent les différentes étapes d'un mode de réalisation particulier d'un procédé d'assemblage d'un support mémoire selon la figure 2, en coupe respectivement selon l'axe B-B de la figure 2 et selon l'axe A-A de la figure 1.
Les figures 7 et 8 représentent un mode de réalisation particulier de la fabrication d'une matrice d'estampage.
La figure 9 représente un mode particulier de réalisation de l'estampage du support mémoire selon la figure 6 par l'intermédiaire de la matrice d'estampage selon les figures 7 et 8.

### Description de modes particuliers de réalisation

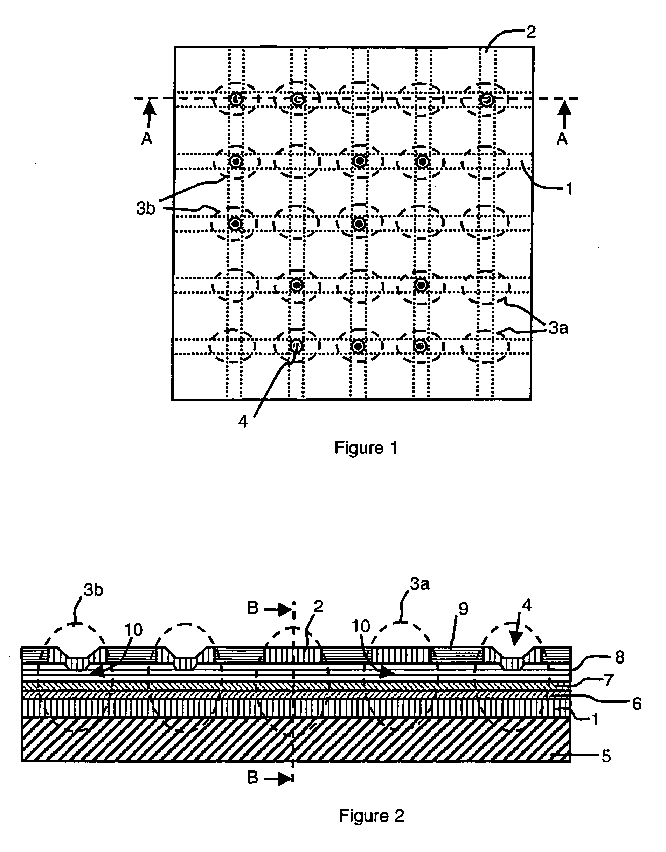

Sur la figure 1, un support mémoire irréversible comporte cinq premiers conducteurs 1, représentés horizontalement en lignes pointillés, et cinq deuxièmes conducteurs 2, représentés verticalement en lignes pointillés. Les conducteurs 1 et 2 sont isolés les uns des autres. Vingt-cinq cellules mémoire 3 sont disposées selon un réseau, respectivement aux intersections des premiers 1 et deuxièmes 2 conducteurs, et adressables par les premier 1 et deuxième 2 conducteurs associés. Des premières cellules mémoire 3a sont dans leur état initial, isolant, tandis que des deuxièmes cellules mémoire 3b ont subi des déformations plastiques 4 localisées, de manière à modifier leur état de conduction. Ainsi, une information est définie soit par une cellule mémoire 3a lorsqu'elle correspond à un premier niveau binaire (par exemple 0), soit par une cellule mémoire 3b lorsqu'elle correspond à un deuxième niveau binaire (par exemple 1).

Sur la figure 2, le support mémoire irréversible selon la figure 1 est représenté en coupe selon l'axe A-A. Un premier conducteur 1 est disposé sur un substrat 5, par exemple en silicium. Sur le premier conducteur 1, un empilement d'une première couche semiconductrice 6 dopée et d'une deuxième couche semiconductrice 7 de dopage opposé constitue une diode associée au premier conducteur 1 représenté. Une couche active 8 est disposée sur les couches semiconductrices 6 et 7. Les deuxièmes conducteurs 2 sont disposés sur la couche active 8 et l'espace entre les deuxièmes conducteurs 2 est rempli, par exemple avec une technique utilisant une résine de planarisation 9 et/ou en utilisant une étape de polissage mécano-chimique, de manière à créer un plan commun avec les deuxièmes conducteurs 2. La couche active 8 est initialement électriquement isolante et peut être rendue électriquement conductrice par déformation plastique 4. Chaque cellule mémoire 3 comporte, entre les premier 1 et deuxième 2 conducteurs associés, une zone 10 de couche active. Les zones 10 de couche active des premières cellules mémoire 3a sont dans leur état initial isolant, tandis que les zones 10 de couche active des deuxièmes cellules mémoire 3b sont sélectivement rendues électriquement conductrices par déformation plastique localisée 4. Ainsi, l'information binaire stockée dans chaque cellule mémoire 3 est déterminée par l'état de conduction électrique de la zone 10 correspondante de la couche active 8.

De préférence, la couche active 8 est constituée par une résine chargée, par exemple chargée d'ions ou de particules conductrices, initialement isolante et devenant conductrice lors qu'elle est comprimée.

Sur la figure 2, chaque cellule mémoire 3 comporte ainsi une diode, constituée par l'empilement des couches semiconductrices 7 et 8, connectée en série avec la zone 10 correspondante de la couche active 8 entre les premier 1 et deuxième 2 conducteurs associés. Cependant, tout élément non-linéaire électronique peut remplacer la diode.

Dans le mode de réalisation particulier représenté aux figures 1 et 2, les premiers 1 et deuxièmes 2 conducteurs constituent respectivement un premier réseau de conducteurs parallèles disposés dans un premier plan, inférieur sur la figure 2, et un deuxième réseau de conducteurs parallèles disposés dans un deuxième plan, supérieur sur la figure 2, et perpendiculaires aux premiers conducteurs 1. De manière générale, cependant, les conducteurs peuvent être agencés selon un réseau quelconque.

Le procédé de réalisation du support mémoire irréversible comporte l'assemblage d'un support mémoire vierge dont la couche active 8 est dans l'état initial isolant, la fabrication d'une matrice d'estampage ayant un motif d'estampage correspondant à l'information à stocker et l'estampage du support mémoire par l'intermédiaire de la matrice d'estampage.

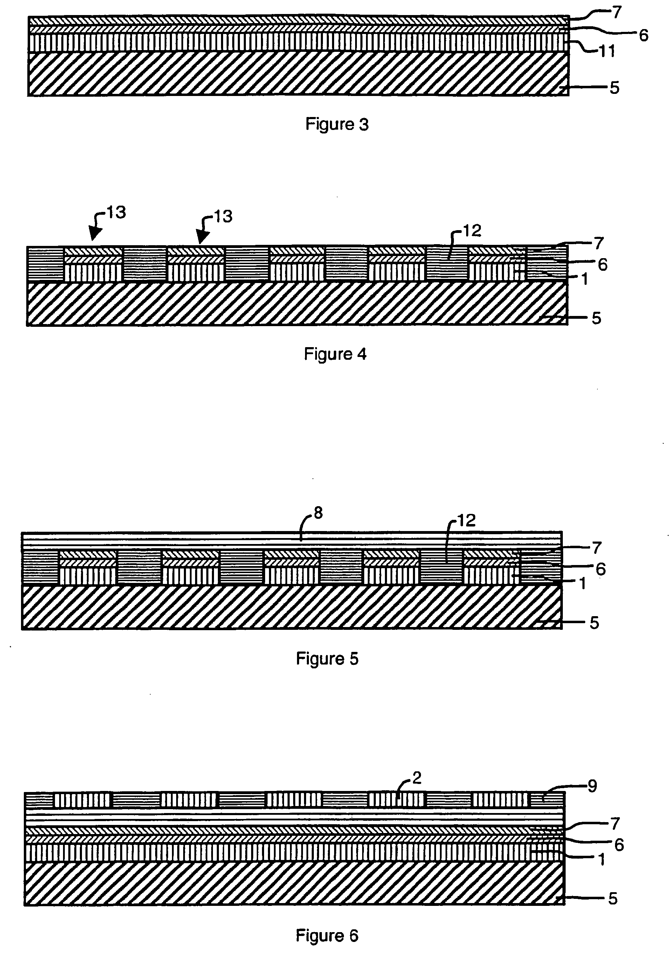

Les figures 3 à 6 illustrent l'assemblage d'un support mémoire vierge. Dans une première étape de l'assemblage, représentée sur la figure 3, une première couche conductrice 11 et deux couches semiconductrices 6 et 7, de dopages opposés, sont successivement déposées sur le substrat 5. La première couche conductrice 11 est, par exemple, en cuivre ou en aluminium.

Une deuxième étape, de gravure des couches 11, 6 et 7, et une troisième étape, de dépôt d'une résine de planarisation 12, sont représentées sur la figure 4. Le remplissage de l'espace entre les bandes 13 du premier réseau de bandes 13 parallèles peut comporter une étape de polissage mécano-chimique. La gravure de l'empilement constitué par la première couche conductrice 11 et les deux couches semiconductrices 6 et 7 est effectuée de manière à délimiter un premier réseau de bandes 13 parallèles. Les premières couches conductrices 11 gravées des bandes 13 ainsi obtenues constituent les premiers conducteurs 1. Le dépôt de la résine de planarisation 12 permet de remplir l'espace entre les bandes 13 du premier réseau de bandes 13 parallèles, de manière à ce que la résine de planarisation 12 crée un plan commun avec les bandes 13 du premier réseau de bandes 13 parallèles.

Ensuite, dans une quatrième étape, représentée à la figure 5, la couche active 8 est déposée sur ledit plan commun.

Une deuxième couche conductrice est déposée sur la couche active 8 dans une cinquième étape et, ensuite, gravée, dans une sixième étape, de manière à former un deuxième réseau de bandes parallèles perpendiculaires aux bandes du premier réseau de bandes. Les bandes ainsi obtenues constituent les deuxièmes conducteurs 2 (figure 6). Dans une septième étape, l'espace entre les deuxièmes conducteurs 2 est rempli, par exemple avec une technique utilisant une résine de planarisation 9 ou en utilisant une étape de polissage mécano-chimique.

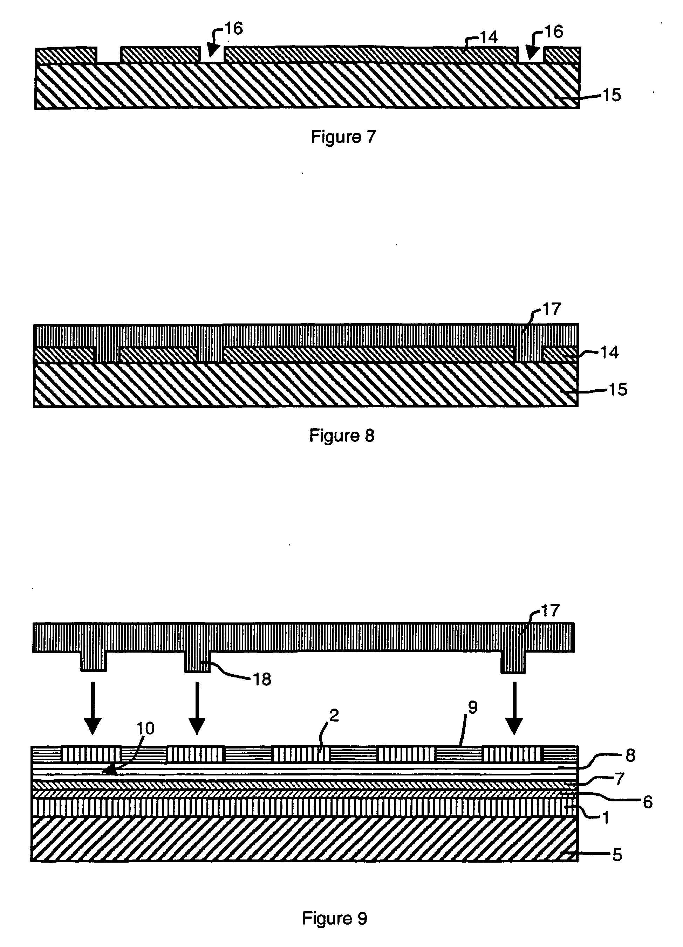

Les figures 7 et 8 illustrent la fabrication d'une matrice d'estampage destinée à stocker irréversiblement une information dans un support mémoire vierge. Sur la figure 7, une résine photosensible 14 est déposée sur un substrat intermédiaire 15. Ensuite, on grave, dans la résine photosensible 14, un réseau de zones élémentaires 16 dont la configuration correspond au motif d'estampage désiré. Comme représenté sur la figure 8, un métal constituant la matrice d'estampage 17 est déposé, de manière à remplir les zones élémentaires 16, par dépôt électrolytique, sur le substrat intermédiaire 15 et sur la résine photosensible 14, qui est, par exemple, revêtue préalablement d'une fine couche conductrice à l'aide d'une technique de dépôt physique en phase vapeur. Ensuite, la matrice d'estampage 17 est détachée du substrat intermédiaire 15 et des résidus de résine photosensible 14 sont enlevés de la matrice d'estampage 17. Ainsi est obtenue une matrice d'estampage 17 comportant des éléments en saillie 18 dont la configuration correspond au motif d'estampage (figure 9) représentatif de l'information à stocker.

Pour l'estampage du support mémoire, comme représenté à la figure 9, le support mémoire et la matrice d'estampage 17 sont alignés et une pression est exercée sur la matrice d'estampage 17, de manière à ce que les éléments en saillie 18 de la matrice d'estampage 17 déforment, à travers le deuxième conducteur 2, les zones 10 de la couche active 8 disposées vis-à-vis des éléments en saillie 18.

La couche active 8 peut également être une couche isolante fine, l'estampage déformant le deuxième conducteur 2 de manière à établir un contact mécanique direct entre le matériau du deuxième conducteur 2 et la diode sous-jacente associée, en écrasant totalement la couche isolante à l'emplacement de la cellule mémoire considérée.

Plusieurs supports mémoire irréversibles peuvent donc être assemblés collectivement par un procédé unique, indépendamment de l'information à stocker et sans étapes de lithographie spécifiques de l'information à stocker. La réalisation d'une série de supports destinés à stocker les mêmes informations nécessite la fabrication d'une seule matrice d'estampage spécifique. L'estampage d'une série de supports, petite ou grande, est moins complexe et réalisable à des coûts plus faible que la réalisation d'étapes de lithographie supplémentaires pour chaque support ou la programmation de chacun des supports d'une série de supports mémoire irréversibles programmables.

## Revendications

1. Procédé de réalisation d'un support mémoire irréversible comportant un réseau de cellules mémoire (3), chaque cellule mémoire (3) comportant une zone (10) d'une couche active (8) disposée entre des premier (1) et deuxième (2) conducteurs, une information binaire stockée dans la cellule mémoire (3) étant déterminée par l'état de conduction électrique de la zone (10) correspondante, procédé **caractérisé en ce qu'**il comporte l'assemblage d'un support mémoire vierge dont la couche active (8) est dans un état initial isolant, la fabrication d'une matrice d'estampage (17) ayant un motif d'estampage correspondant à l'information à stocker et l'estampage du support mémoire par l'intermédiaire de la matrice d'estampage (17), de manière à rendre des zones prédéterminées (10) de la couche active (8) électriquement conductrices par déformation plastique localisée (4).

2. Procédé selon la revendication 1, **caractérisé en ce que** la couche active (8) est constituée par une résine chargée.

3. Procédé selon l'une des revendications 1 et 2, **caractérisé en ce que** l'assemblage d'un support mémoire vierge comporte successivement
- le dépôt, sur un substrat (5), d'une première couche conductrice (11) et de deux couches semiconductrices (6, 7) de dopages opposés,
- la gravure de l'empilement constitué par la première couche conductrice (11) et les deux couches semiconductrices (6, 7), de manière à obtenir un premier réseau de bandes (13) parallèles,
- le remplissage de l'espace entre les bandes (13) du premier réseau de bandes (13) parallèles, de manière à créer un plan commun avec les bandes (13) du premier réseau de bandes (13) parallèles,
- le dépôt de la couche active (8) sur ledit plan commun,
- le dépôt d'une deuxième couche conductrice sur la couche active (8),
- la gravure de la deuxième couche conductrice, de manière à obtenir un deuxième réseau de bandes parallèles perpendiculaires aux bandes (13) du premier réseau de bandes (13),
- le remplissage de l'espace entre les bandes du deuxième réseau de bandes parallèles.

4. Procédé selon la revendication 3, **caractérisé en ce que** l'espace entre les bandes du premier et/ou deuxième réseau de bandes parallèles est rempli avec une technique utilisant une résine de planarisation (12, 9).

5. Procédé selon la revendication 3, **caractérisé en ce que** l'espace entre les bandes du premier et/ou deuxième réseau de bandes parallèles est rempli en utilisant une étape de polissage mécano-chimique.

6. Procédé selon l'une quelconque des revendications 1 à 5, **caractérisé en ce que** la fabrication de la matrice d'estampage (17) comporte successivement
- le dépôt d'une résine photosensible (14) sur un substrat intermédiaire (15),
- la gravure, dans la résine photosensible (14), d'un réseau de zones élémentaires (16) dont la configuration correspond au motif d'estampage,
- le dépôt électrolytique, sur le substrat intermédiaire (15) et la résine photosensible (14), d'un métal constituant la matrice d'estampage (17),
- le détachement de la matrice d'estampage (17) du substrat intermédiaire (15),
- l'enlèvement de résidus de résine photosensible (14) de la matrice d'estampage (17).

## Claims

1. Method for producing an irreversible storage medium comprising an array of memory cells (3), each memory cell (3) comprising one zone (10) of an active layer (8) arranged between first (1) and second (2) conductors, binary information stored in the memory cell (3) being determined by the electrical conducting state of the corresponding zone (10), method **characterized in that** it comprises assembly of a blank storage medium having an active layer (8) which is in an initial insulating state, production of a stamping die (17) having a stamping pattern that corresponds to the information to be stored, and stamping of the storage medium using the stamping die (17) so as to make predetermined zones (10) of the active layer (8) electrically conductive by means of localised plastic deformation (4).

2. Method according to claim 1, **characterized in that** the active layer (8) is formed by a charged resin.

3. Method according to one of the claims 1 and 2, **characterized in that** assembly of a blank storage medium successively comprises
- deposition, on a substrate (5), of a first conducting layer (11) and of two oppositely doped semi-conducting layers (6, 7),
- etching of the stack formed by the first conducting layer (11) and the two semi-conducting layers (6, 7), so as to obtain a first array of parallel strips (13),
- filling the space between the strips (13) of the first array of parallel strips (13) so as to create a common plane with the strips (13) of the first array of parallel strips (13),
- deposition of the active layer (8) on said common plane,
- deposition of a second conducting layer on the active layer (8),
- etching of the second conducting layer, so as to obtain a second array of parallel strips perpendicular to the strips (13) of the first array of strips (13),
- filling the space between the strips of the second array of parallel strips.

4. Method according to claim 3, **characterized in that** the space between the strips of the first and/or second array of parallel strips is filled by means of a technique using a planarization resin (12, 9).

5. Method according to claim 3, **characterized in that** the space between the strips of the first and/or second array of parallel strips is filled by means of a mechanical-chemical polishing step.

6. Method according to any one of the claims 1 to 5, **characterized in that** production of the stamping die (17) successively comprises
- deposition of a photoresist (14) on an intermediate substrate (15),
- etching, in the photoresist (14), of an array of elementary zones (16) having a configuration corresponding to the stamping pattern,
- electrolytic deposition, on the intermediate substrate (15) and the photoresist (14), of a metal constituting the stamping die (17),
- detachment of the stamping die (17) from the intermediate substrate (15),
- removal of the residues of photoresist (14) from the stamping die (17).

## Patentansprüche

1. Verfahren zur Herstellung eines irreversiblen Speichers mit einem Netz von Speicherzellen (3), wobei jede Speicherzelle (3) eine Zone (10) einer aktiven Schicht (8) aufweist, die zwischen einem ersten (1) und einem zweiten Leiter (2) angeordnet ist, wobei eine in der Speicherzelle (3) gespeicherte Binärinformation durch den elektrischen Leitungszustand der entsprechenden Zone (10) bestimmt ist, wobei das Verfahren **dadurch gekennzeichnet ist, dass** es den Zusammenbau eines unbelichteten Speicherträgers, dessen aktive Schicht (8) sich in einem anfänglich isolierenden Zustand befindet, die Herstellung einer Prägematrize (17) mit einem Prägemuster, das der zu speichernden Information entspricht und das Prägen des Speicherträgers über die Prägematrize (17) derart umfasst, dass vorbestimmte Zonen (10) der aktiven Schicht (8) durch lokalisierte plastische Verformung (4) elektrisch leitend gemacht werden.

2. Verfahren nach Anspruch 1, **dadurch gekennzeichnet, dass** die aktive Schicht (8) durch ein geladenes Harz gebildet ist.

3. Verfahren nach einem der Ansprüche 1 und 2, **dadurch gekennzeichnet, dass** der Zusammenbau eines unbelichteten Speicherträgers nacheinander umfasst:
- Aufbringen einer ersten leitenden Schicht (11) und zweier Halbleiterschichten (6, 7) mit entgegengesetzten Dotierungen auf ein Substrat (5),
- Ätzen des durch die erste leitende Schicht (11) und die zwei Halbleiterschichten (6, 7) gebildeten Stacks, sodass ein erstes Netz von parallelen Bändern (13) erhalten wird,
- Füllen des Raums zwischen den Bändern (13) des ersten Netzes von parallelen Bändern, sodass eine gemeinsame Ebene mit den Bändern (13) des ersten Netzes von parallelen Bändern (13) geschaffen wird,
- Aufbringen der aktiven Schicht (8) auf die gemeinsame Ebene,
- Aufbringen einer zweiten leitenden Schicht auf die aktive Schicht (8),
- Ätzen der zweiten leitenden Schicht, sodass ein zweites Netz von parallelen Bändern senkrecht zu den Bändern (13) des ersten Netzes von Bändern (13) erhalten wird,
- Füllen des Raumes zwischen den Bändern des zweiten Netzes von parallelen Bändern.

4. Verfahren nach Anspruch 3, **dadurch gekennzeichnet, dass** der Raum zwischen den Bändern des ersten und/oder zweiten Netzes von parallelen Bändern mit einer Technik gefüllt wird, die ein Planarisierungsharz (12, 9) verwendet.

5. Verfahren nach Anspruch 3, **dadurch gekennzeichnet, dass** der Raum zwischen den Bändern des ersten und/oder zweiten Netzes von parallelen Bändern gefüllt wird, indem ein Schritt chemisch-mechanischen Polierens verwendet wird.

6. Verfahren nach einem der Ansprüche 1 bis 5, **dadurch gekennzeichnet, dass** die Herstellung der Prägematrize (17) nacheinander umfasst:
- Aufbringen eines lichtempfindlichen Harzes (14) auf ein Zwischensubstrat (15),
- Ätzen eines Netzes von Elementzonen (16), dessen Konfiguration dem Prägemuster entspricht, in dem lichtempfindlichen Harz (14),
- Elektrolytisches Aufbringen eines Metalls, das die Prägematrize (17) bildet, auf das Zwischensubstrat (15) und das lichtempfindliche Harz (14),
- Ablösen der Prägematrize (17) von dem Zwischensubstrat (15),
- Entfernen von Resten von lichtempfindlichem Harz (14) von der Prägematrize (17).
